# FASCICULE DE BREVET EUROPEEN

(11) **EP 4 105 999 B1**
(45) Date de publication et mention de la délivrance du brevet: **17.04.2024**
(21) Numéro de dépôt: 22178992.8
(22) Date de dépôt: 14.06.2022
(51) Int. Cl.: H01L 27/15, H01L 33/16

(54) **PROCEDE DE FABRICATION D'UNE MATRICE A EMISSION NATIVE**
VERFAHREN ZUR HERSTELLUNG EINER NATIVEN EMISSIONSMATRIX
METHOD FOR MANUFACTURING A MATRIX WITH NATIVE TRANSMISSION

(30) Priorité: 16.06.2021 FR 2106387
(43) Date de publication de la demande: 21.12.2022
(73) Titulaire: Commissariat à l'énergie atomique et aux énergies alternatives, 75015 Paris (FR)
(72) Inventeur: DUPRE, Ludovic, 38054 GRENOBLE CEDEX 09 (FR); PERNEL, Carole, 38054 GRENOBLE CEDEX 09 (FR); DUSSAIGNE, Amélie, 38054 Grenoble CEDEX 09 (FR); LE MAITRE, Patrick, 38054 GRENOBLE CEDEX 09 (FR)
(74) Mandataire: Brevalex

(56) Documents cités:
- WO-A1-2021/050731

## Description

### DOMAINE TECHNIQUE

La présente invention se rapporte au domaine général des micro-écrans couleur.

L'invention concerne un procédé pour fabriquer une matrice à émission native, et notamment une matrice RGB.

L'invention concerne également une matrice à émission native, et notamment une matrice RGB.

L'invention trouve des applications dans de nombreux domaines industriels, et notamment dans le domaine des micro-écrans couleur à base de micro-LEDs au pas inférieur à 10 µm.

### ÉTAT DE LA TECHNIQUE ANTÉRIEURE

Les micro-écrans couleurs comprennent des pixels bleus, verts et rouges (pixels RGB).

Les pixels bleus et verts peuvent être fabriqués à base de matériaux nitrures et les pixels rouges à base de matériaux phosphures. Pour combiner sur le même substrat ces trois types de pixels, la technique dite de « pick and place » est généralement utilisée. Cependant, dans le cas des micro-écrans avec des pixels inférieurs à 10 µm, cette technique ne peut plus être utilisée à cause, non seulement, des problèmes d'alignement, mais aussi du temps nécessaire pour réaliser une telle technique à cette échelle.

Une autre solution consiste à réaliser la conversion de couleurs avec des boîtes quantiques (QD pour « Quantum Dot » en langue anglaise) ou des nanophosphores. Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'InN dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Pour remédier à cette problématique, plusieurs solutions ont été envisagées.

Une première solution consiste à former des nanostructures, comme des nanofils ou des pyramides, pour pouvoir relaxer les contraintes par les bords libres. La croissance des nanofils axiaux peut être réalisée par épitaxie par jets moléculaires (ou MBE pour « Molecular Beam Epitaxy »). En pratique, la faible température de croissance utilisée en croissance par MBE conduit à des faibles rendements quantiques internes (IQE). Les pyramides permettent de courber les dislocations. En particulier, les pyramides complètes ont des plans semi-polaires favorables à l'incorporation d'In et à la réduction du champ électrique interne de la zone active. Pour des pyramides tronquées, les faces tronquées permettent une croissance des puits quantiques sur le plan c, ce qui conduit à une émission plus homogène par rapport à une émission le long des plans semi-polaires d'une pyramide complète. Alternativement, la croissance peut aussi se faire en planaire sur des plans autres que la face c de la structure wurtzite comme la croissance sur les plans semi-polaires qui sont plus favorables à l'incorporation d'In.

Une autre solution consiste à réduire les contraintes dans la zone active de la structure LED en utilisant un substrat ou pseudo-substrat avec un paramètre de maille plus proche du paramètre de maille de l'alliage InGaN des puits quantiques. Ainsi, même avec une configuration planaire, on peut augmenter le taux d'incorporation d'In dans l'InGaN. Il a été montré que, lorsque le paramètre de maille du substrat augmente, le champ électrique interne est réduit par comparaison à une couche contrainte de même concentration en In et les émissions des puits quantiques sont décalées vers le rouge [1]. La couche relaxée d'InGaN obtenue permet de faire croître une hétérostructure III-N par épitaxie en phase vapeur aux organométalliques (ou MOVPE pour « metalorganic vapor phase epitaxy »). Cependant, à ce jour, à notre connaissance, le seul substrat ayant permis cette démonstration est le pseudo-substrat InGaNOS de Soitec obtenu par la technique de Smart Cut^{™}.

Une autre solution pour réduire les contraintes globales dans les structures LEDs à base de GaN/InGaN consiste à porosifier la couche de GaN. Dans la référence [2], on prépare dans un premier temps un empilement comprenant un substrat en saphir recouvert par une couche de GaN non intentionnellement dopée (GaN nid) et une couche de GaN dopée n+. La couche de GaN dopée joue le rôle d'anode et une grille en platine joue le rôle de cathode. La porosification électrochimique est réalisée dans une solution d'acide oxalique (0,2M) en appliquant une tension de 15V pendant 30min-puis sous rayonnement ultra-violet dans une solution de KOH (0,06M) à 9V pendant 30min. La couche porosifiée de GaN ainsi obtenue permet de faire croître une structure LED à puits quantiques multiples (MQWs pour « multiple quantum wells ») composée d'une couche de GaN n+, cinq puits quantiques (PQs) Gan/InGaN et une couche de contact GaN p. La relaxation importante des contraintes conduit à de meilleures propriétés électriques et optiques, notamment en ce qui concerne la photoluminescence (PL).

Cependant, la qualité cristalline de la couche de GaN de la LED dépend du diamètre des pores et de la porosité de la couche de GaN porosifiée, ainsi que de l'épaisseur recherchée. Il est donc nécessaire de trouver les paramètres adéquats à chaque fois, ce qui complique l'industrialisation du procédé.

La fabrication d'une couche d'InGaN épitaxiée relaxée à partir d'un substrat GaN/InGaN et la fabrication d'une couche d'InGaN épitaxiée relaxée sur des mésas d'InGaN ont été réalisées avec des procédés de porosification mettant en oeuvre une anodisation électrochimique. L'étape de porosification est mise en oeuvre pleine plaque grâce à différents reports [3,4]. Le document WO 2021/050731 A1 décrit une matrice à émission native et son procédé de fabrication.

### EXPOSÉ DE L'INVENTION

Un but de la présente invention est de proposer un procédé remédiant au moins en partie aux inconvénients de l'art antérieur, et permettant d'obtenir une structure GaN/InGaN au moins partiellement voire totalement relaxée, en vue de fabriquer une matrice à émission native et notamment une matrice RGB (« Red Green Blue ») ayant des pixels rouge vert bleu.

Pour cela, la présente invention propose un procédé pour fabriquer une matrice à émission native comprenant les étapes suivantes :
a) fournir une structure de base comprenant successivement un substrat, une couche de GaN non intentionnellement dopée (nid), une couche d'ln(x)GaN dopée avec x une valeur choisie dans la gamme de 0 à 8% et une couche de reprise d'épitaxie en In(x)GaN non intentionnellement dopée,
b1) structurer une première mésa dans la structure de base comprenant une partie de la couche de GaN nid, la couche d'ln(x)GaN dopée et la couche de reprise d'épitaxie en In(x)GaN non intentionnellement dopée ,
b2) structurer une deuxième mésa dans la structure de base, la deuxième mésa comprenant une partie de la couche d'ln(x)GaN dopée et la couche de reprise d'épitaxie en In(x)GaN non intentionnellement dopée, la première mésa étant isolée électriquement de la deuxième mésa,
c) porosifier par voie électrochimique la couche d'ln(x)GaN dopée de la deuxième mésa,
d1) déposer un premier empilement sur la couche de reprise d'épitaxie en In(x)GaN non intentionnellement dopée de la première mésa, moyennant quoi on obtient une première structure de LED émettant à une première longueur d'onde, par exemple bleue,
d2) déposer un deuxième empilement sur la couche de reprise d'épitaxie en In(x)GaN non intentionnellement dopée de la deuxième mésa, moyennant quoi on obtient une deuxième structure de LED émettant à une deuxième longueur d'onde, par exemple rouge.

L'invention se distingue fondamentalement de l'art antérieur par la mise en oeuvre d'une structure de base (substrat dit patterné) comprenant plusieurs mésas ayant différents taux de relaxation pour la fabrication de matrices à émission native. Lors de la reprise d'épitaxie d'un ou de plusieurs empilements de couches sur ces mésas, on obtient ainsi des structures de LEDs ayant différentes longueur d'ondes.

Le procédé conduit à une porosification sélective des mésas grâce à un adressage électrique particulier. Les mésas qui ne doivent pas être porosifiées sont isolées électriquement grâce à une gravure jusqu'à une couche non dopée.

Les étapes de porosification et d'épitaxie successives conduisent à l'obtention de plusieurs longueurs d'onde d'émission.

Avantageusement, le procédé comporte en outre une étape b3) au cours de laquelle on structure une troisième mésa dans la structure de base et une étape d3) au cours de laquelle on dépose un troisième empilement sur la couche de reprise d'épitaxie en In(x)GaN non intentionnellement dopée de la troisième mésa, moyennant quoi on obtient une troisième structure de LED émettant à une troisième longueur d'onde, par exemple verte.

Avantageusement, la première structure de LED émet dans le bleu, la deuxième structure de LED émet dans le rouge et la troisième structure de LED émet dans le vert, moyennant quoi on forme une matrice RGB.

Selon une première variante de réalisation avantageuse, la troisième mésa comprend une partie de la couche de GaN nid, la couche d'ln(x)GaN dopée et la couche de reprise d'épitaxie en In(x)GaN non intentionnellement dopée. La troisième mésa est isolée électriquement de la première mésa et de la deuxième mésa.

Selon cette première variante, avantageusement, l'étape b3) est réalisée simultanément à l'étape b1) et/ou l'étape d3) est réalisée simultanément à l'étape d2).

Avantageusement, l'étape d3) est réalisée simultanément à l'étape d2) : le même empilement de couches est déposé sur la deuxième mésa et sur la troisième mésa. Les paramètres de croissance sont identiques mais les structures de LED résultantes sont différentes puisque la concentration en In de chacune des couches va varier en fonction de l'état de contrainte de la mésa.

Avantageusement, selon cette première variante :
- entre l'étape c) et l'étape d1), on dépose un premier masque en SiO₂ ou SiN sur la deuxième mésa et la troisième mésa, le premier masque étant retiré après l'étape d1), et
- entre l'étape d1) et les étapes d2) et d3), on dépose un deuxième masque en SiO₂ ou SiN sur la première mésa, le deuxième masque étant retiré après les étapes d2) et d3).

Selon une seconde variante de réalisation avantageuse, la troisième mésa comprend une partie de la couche d'ln(x)GaN dopée et la couche de reprise d'épitaxie en In(x)GaN non intentionnellement dopée, moyennant quoi la troisième mésa est isolée électriquement de la deuxième mésa, et le procédé comprend une étape additionnelle c') au cours de laquelle on porosifie par voie électrochimique la couche d'ln(x)GaN dopée de la troisième mésa.

Selon cette seconde variante, avantageusement, les étapes d1, d2) et d3) sont réalisées simultanément. L'incorporation d'In dans la totalité de la structure, et notamment dans les puits quantiques est variable en fonction du taux de relaxation de la couche de reprise d'épitaxie dense. Plus la couche est relaxée et plus la longueur d'onde d'émission augmente. Ainsi, en déposant le même empilement de couches sur les trois mésas on obtient plusieurs structures de LEDs émettant à différentes longueurs d'onde, les première, deuxième et troisième structures étant, avantageusement, adaptées pour émettre respectivement dans le bleu, le rouge et le vert.

Les étapes c) et c') peuvent être réalisées simultanément ou successivement.

Avantageusement, la couche de GaN nid a une épaisseur comprise entre 100nm et 4µm et/ou la couche d'ln(x)GaN dopée a une épaisseur comprise entre 100nm et 800nm et/ou la couche de reprise d'épitaxie en In(x)GaN non intentionnellement dopée a une épaisseur comprise entre 10nm et 200nm.

Le procédé présente de nombreux avantages :
- il est simple à mettre en oeuvre,
- la structuration en mésa associée à la porosification de la couche dopée n apportent l'effet de compliance,
- il conduit à une relaxation partielle ou totale des contraintes et diminue la polarisation piézo-électrique par comparaison à une couche contrainte de même concentration en In,
- il permet une approche dite « bottom up » pour la fabrication de µLED et µdisplay : la croissance des structures optiques (N, PQs, P) est réalisée après pixélisation en mésa, quel que soit la taille des pixels, et permet de s'affranchir des problèmes d'alignement comme pour le procédé « pick and place » ; de plus, il n'y a pas d'impact du procédé de gravure des pixels sur l'efficacité des micro-LEDs, ce qui rend possible la réalisation de pixel micrométrique,
- limitation du nombre d'épitaxie nécessaire pour obtenir la matrice RGB : 2 épitaxies au maximum au lieu de trois,
- utilisation possible de la structure LED bleue classique pour le pixel bleu et utilisation possible de la structure LED tout InGaN adaptée pour le rouge à la fois pour le pixel vert et pour le pixel rouge (grâce à un taux de relaxation adapté de la mésa poreuse pour la structure LED rouge), ce qui permet de maximiser l'EQE pour le Bleu et le Rouge,
- ajustement précis de la relaxation des mésas via une étape de porosification adaptée pour le contrôle de la longueur d'onde d'émission,
- le procédé ne nécessite pas d'étape de report pour pouvoir porosifier la couche dopée.

L'invention concerne également une matrice à émission native comprenant :
- une structure de base comprenant successivement un substrat, une couche de GaN nid, une couche d'ln(x)GaN dopée avec x de 0 à 8% et une couche de reprise d'épitaxie en In(x)GaN non intentionnellement dopée,
- une première mésa formée dans la structure de base comprenant une partie de la couche de GaN (nid), la couche d'ln(x)GaN dopée et la couche de reprise d'épitaxie en In(x)GaN non intentionnellement dopée, la première mésa étant recouverte par une première structure de LED émettant à une première longueur d'onde, par exemple bleue,
- une deuxième mésa formée dans la structure comprenant une partie de la couche d'ln(x)GaN dopée et la couche de reprise d'épitaxie en In(x)GaN non intentionnellement dopée, la couche d'ln(x)GaN dopée de la deuxième mésa étant porosifiée, la deuxième mésa étant recouverte par une deuxième structure de LED émettant à une deuxième longueur d'onde, par exemple rouge.

Avantageusement, la matrice comprend une troisième mésa formée dans la structure de base et recouverte par une troisième structure de LED, émettant à une troisième longueur d'onde, par exemple verte.

Selon une première variante de réalisation avantageuse, la troisième mésa comprend une partie de la couche de GaN nid, la couche d'ln(x)GaN dopée et la couche de reprise d'épitaxie en In(x)GaN non intentionnellement dopée.

Selon cette première variante, avantageusement, la troisième structure de LED est formée simultanément à la deuxième structure de LED.

Selon une seconde variante de réalisation avantageuse, la troisième mésa comprend une partie de la couche d'ln(x)GaN dopée et la couche de reprise d'épitaxie en In(x)GaN non intentionnellement dopée, la couche d'ln(x)GaN dopée de la troisième mésa étant porosifiée.

Selon cette seconde variante, avantageusement, la première structure de LED, la deuxième structure de LED et la troisième structure de LED sont formées simultanément.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les figures 1A à 1J représentent, de manière schématique et en coupe différentes étapes d'un procédé de fabrication d'une matrice RGB selon une première variante de réalisation particulière de l'invention.
La figure 2 représente, de manière schématique et en coupe, une structure LED selon un mode de réalisation particulier de l'invention.
La figure 3 représente, de manière schématique et en coupe, une structure LED selon un autre mode de réalisation particulier de l'invention.
La figure 4 représente, de manière schématique et en coupe, une structure LED selon un autre mode de réalisation particulier de l'invention.
Les figures 5A à 5F représentent, de manière schématique et en coupe différentes étapes d'un procédé de fabrication d'une matrice RGB selon une seconde variante de réalisation particulière de l'invention.
Les figures 6A et 6B représentent, de manière schématique et en trois dimensions, des étapes de gravure des séries de mésas, selon un mode de réalisation particulier de la seconde variante de réalisation.
La figure 7 représente, de manière schématique et en vue de dessus, les interconnexions électriques des séries de mésas, selon un mode de réalisation particulier de la seconde variante de réalisation.
La figure 8 représente, de manière schématique et en coupe, une structure LED selon un autre mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », «dessous », etc. d'une structure s'appliquent en considérant que la structure est orientée de la façon illustrée sur les figures.

### EXPOSÉ DÉTAILLÉ DE MODES DE RÉALISATION PARTICULIERS

Bien que cela ne soit aucunement limitatif, l'invention trouve particulièrement des applications pour fabriquer un dispositif multispectral, par exemple des LEDs de différentes couleurs de façon simplifiée, ou un micro-écran (« micro-display ») multicouleurs.

Par la suite, nous allons plus particulièrement décrire le procédé de fabrication d'une matrice à émission native de type RGB (i.e. avec trois longueurs d'onde d'émission différentes), mais le procédé peut s'appliquer à toute matrice ayant au moins deux longueurs d'onde d'émission différentes.

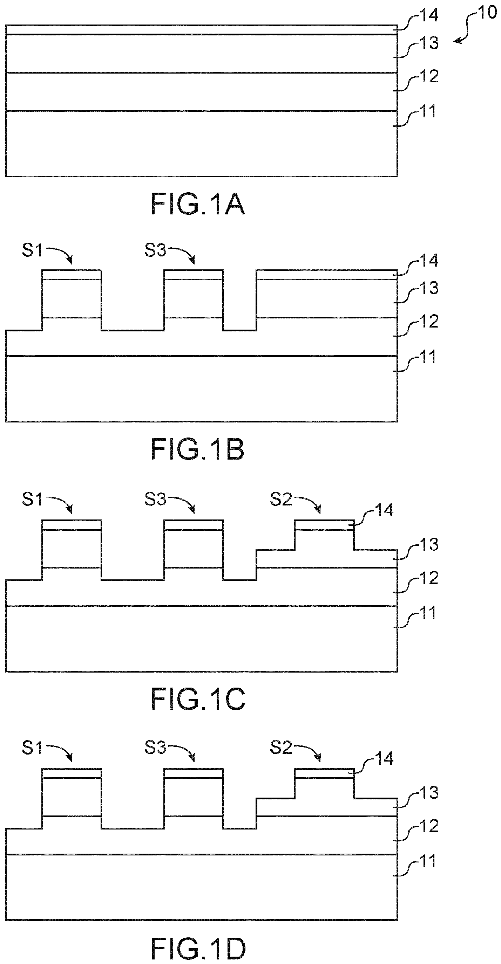

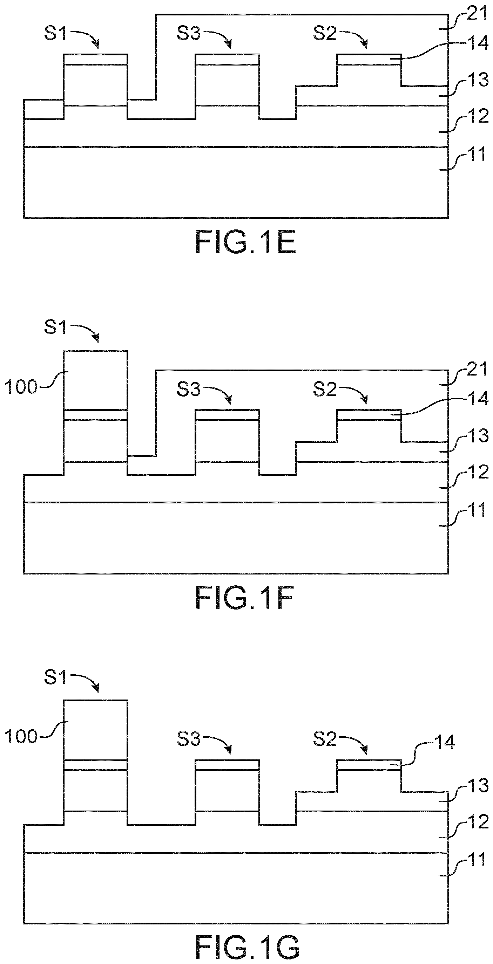

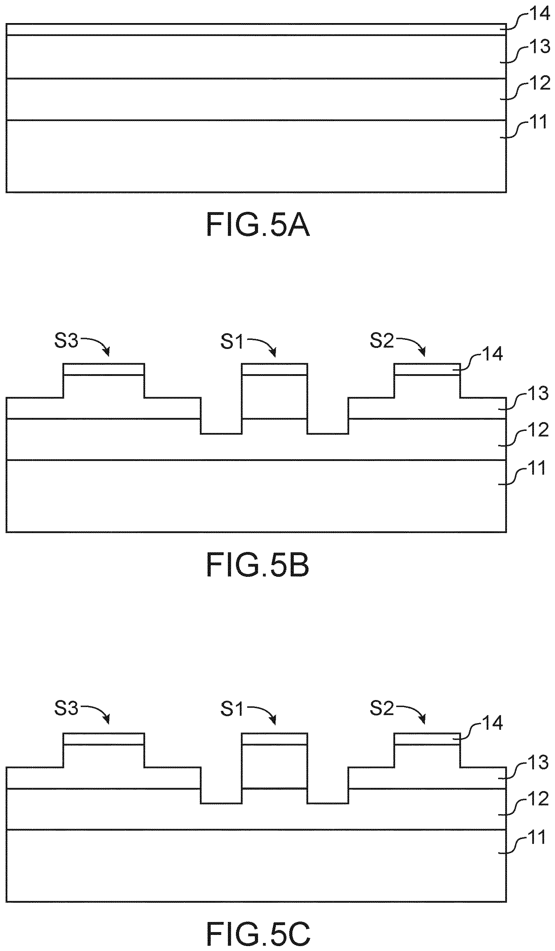

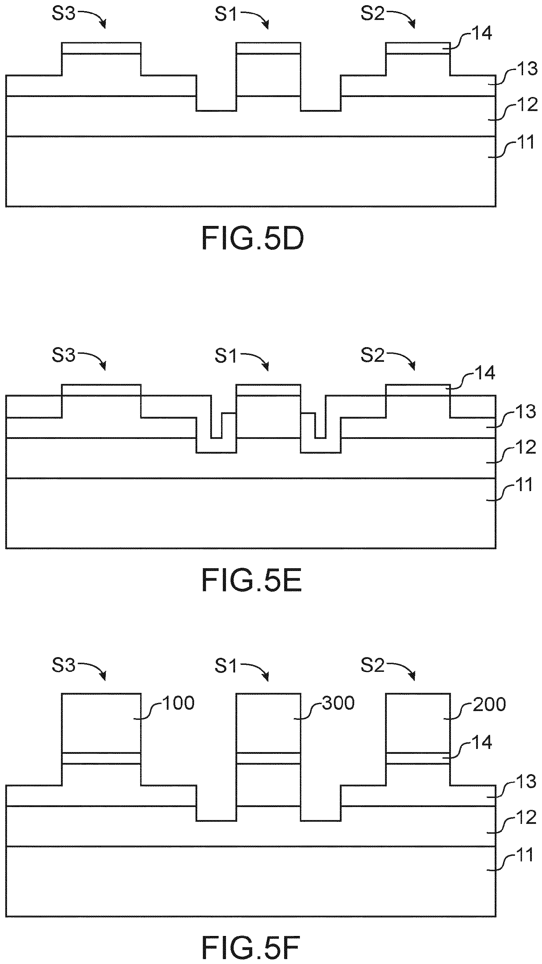

En faisant référence aux figures annexées, nous allons maintenant décrire le procédé de fabrication d'une matrice RGB. Ce procédé peut être réalisé selon plusieurs variantes de réalisation. En particulier, il peut être réalisé selon une première variante de réalisation (représentée sur les figures 1A-1J) et selon une deuxième variante de réalisation (représentée sur les figures 5A-5F). Ces procédés mettent en oeuvre les étapes suivantes :
a) fournir une structure de base 10 comprenant successivement un substrat 11, une couche de GaN nid 12, une couche d'ln(x)GaN dopée 13 avec x de 0 à 8% et une couche de reprise d'épitaxie en In(x)GaN non intentionnellement dopée 14 (figures 1A et 5A),
b) réaliser des étapes b1), b2) et b3) pour structurer, respectivement, une première série de mésas S1, une deuxième série de mésas S2 et une troisième série de mésas S3 dans la structure de base 10 (figures 1B-1C et 5B),
c) porosifier par voie électrochimique la couche d'ln(x)GaN dopée 13 d'au moins une série de mésas (figures 1D et 5C-5D),
d) déposer un ou plusieurs empilements de couches 100 ou 110, 200, 300 sur les couches de reprise d'épitaxie en In(x)GaN non intentionnellement dopée 14 de la première série de mésas S1, de la deuxième série de mésas S2 et de la troisième séries de mésas S3, moyennant quoi on obtient, respectivement, une première série de LED bleue, une deuxième série de LED rouge, et une troisième série de LED verte (figures 1E-1J et 5E-5F).

Le ou les empilements destinés à former les LED sont, avantageusement, formées sur des séries de mésas pour obtenir des séries de LEDs de différentes couleurs. Chaque série de mésas comprend au moins une mésa et de préférence plusieurs mésas.

La structure de base 10 pour ces deux variantes de réalisation du procédé comprend, et de préférence est constituée de (figures 1A et 5A) :
- un substrat 11,
- une couche de GaN nid 12,
- une couche d'ln(x)GaN dopée 13 avec x une valeur choisie dans la gamme allant de 0 à 8%,
- une couche de reprise d'épitaxie en In(x)GaN non intentionnellement dopée 14 avec x une valeur choisie dans la gamme allant de 0 à 8%.

Le substrat 11 est par exemple en saphir ou en silicium. Il a une épaisseur par exemple entre 300µm et 1mm.

La couche de GaN 12 est une couche non intentionnellement dopée (nid). Elle a une épaisseur par exemple entre 100nm et 6 µm.

La couche d'ln(x)GaN dopée 13 a un taux d'In x entre 0% et 8%. Il peut donc s'agir d'une couche de GaN ou d'une couche d'InGaN. Elle est, par exemple, dopée N de 3.10¹⁸cm⁻³ à 1,5.10¹⁹cm⁻³, de préférence de 6.10¹⁸cm⁻³ à 1,5.10¹⁹cm⁻³. Cette couche peut être porosifiée. Elle a, de préférence, une épaisseur comprise entre 100nm et 1µm, par exemple entre 800nm et 1µm.

La couche de reprise d'épitaxie en In(x)GaN est non intentionnellement dopée 14. Elle a un taux d'In x entre 0% et 8%. Il peut donc s'agir d'une couche de GaN ou d'une couche d'InGaN. Elle a par exemple une épaisseur entre 10nm et 200nm.

Lors des étapes b1), b2) et b3), on structure, respectivement, une première série de mésas S1, une deuxième série de mésas S2 et une troisième série de mésas S3 dans la structure de base 10. Pour des soucis de clarté, une seule mésa est représentée par série sur les figures en coupe.

Les mésas, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est généralement une gravure plasma (ou gravure sèche), par exemple à base de gaz chloré Cl₂ ou SiCl₄. Les mésas peuvent être formées dans la structure de base 10 par exemple par photolithographie. Les reliefs permettent de définir des pixels.

De préférence, les flancs des mésas sont perpendiculaires à cet empilement de couches.

Les mésas peuvent avoir une forme carrée, circulaire ou hexagonale. Les dimensions des mésas vont, par exemple, de 500nm à 500µm.

L'espacement (« pitch ») entre deux mésas consécutives va, par exemple, de 50nm à 20µm.

Lors d'une étape b1), on structure une première série de mésas S1 dans la structure de base 10, les mésas de la première série S1 comprenant une partie de la couche de GaN nid 12, la couche d'ln(x)GaN dopée 13 et la couche de reprise d'épitaxie en In(x)GaN non intentionnellement dopée 14, moyennant quoi les mésas de la première série S1 sont chacune isolées électriquement (figures 1B, 5B),

L'étape b1) conduit à une isolation électrique de la première série de mésas S1 grâce à une gravure jusque dans la couche de GaN nid 12. Ces mésas ne seront pas porosifiées lors de l'étape de porosification électrochimique (étape c)).

Lors d'une étape b2), on structure une deuxième série de mésas S2 dans la structure de base 10, les mésas de la deuxième série comprenant une partie de la couche d'ln(x)GaN dopée 13 et la couche de reprise d'épitaxie en In(x)GaN non intentionnellement dopée 14, moyennant quoi les mésas de la deuxième série S2 sont interconnectées électriquement entre elles (figure 1C, 5B),

L'étape b2) conduit à la formation d'une deuxième série de mésas S2 interconnectés électriquement grâce à une gravure jusque dans la couche d'ln(x)GaN dopée 13. Toutes les mésas formées par cette gravure sont connectées électriquement par la couche dopée. Ces mésas seront porosifiées lors de l'étape de porosification électrochimique (étape c)).

Lors de l'étape c), on porosifie sélectivement au moins les mésas de la deuxième série de mésas S2 interconnectées par la couche dopée.

Cette étape est réalisée selon les sous-étapes suivantes :
- relier électriquement la couche électriquement conductrice d'ln(x)GaN dopée 13 de la structure de base 10 et une contre-électrode à un générateur de tension ou de courant,
- plonger la structure de base 10 et la contre-électrode dans une solution électrolytique,
- appliquer une tension ou un courant entre la couche d'ln(x)GaN dopée 13 et la contre-électrode de manière à porosifier la couche d'ln(x)GaN dopée 13 des mésas connectées électriquement au générateur.

Lors de l'étape d'anodisation, la couche dopée 13 joue le rôle d'électrode de travail (WE).

La contre-électrode est en un matériau électriquement conducteur noble et inerte chimiquement (pour éviter la contamination du bain avec des ions provenant de cette électrode), comme par exemple un métal tel que le platine.

Les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, HNO₃, NaNO₃, H₂SO₄ ou un de leurs mélanges. On pourra utiliser par exemple un mélange d'acide oxalique et de NaNO₃.

La tension appliquée entre la couche dopée 13 et la contre-électrode peut aller de 1 à 100V. Elle est appliquée, par exemple, pendant une durée allant de quelques secondes à plusieurs heures. La porosification est complète lorsqu'il n'y a plus de courant à potentiel imposé. A ce moment-là, toute la couche 13 est porosifiée et la réaction électrochimique s'arrête.

L'étape d'anodisation électrochimique peut être réalisée sous lumière ultra-violette (UV). Le procédé peut également comporter une première anodisation électrochimique sans ajouter de rayonnement ultra-violet et une seconde anodisation électrochimique en ajoutant un rayonnement ultra-violet.

Avantageusement, la porosification a lieu dans tout le volume de la couche d'ln(x)GaN dopée 13 des mésas reliées électriquement entre elles.

A l'issue de l'étape de porosification, le taux de porosité de la couche d'ln(x)GaN dopée 13 est d'au moins 10%. Il va de préférence de 25% à 60%.

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

La porosification obtenue (taux de porosité et taille des pores) dépend du dopage de la couche d'ln(x)GaN dopée 13 des mésas et des paramètres du procédé (tension appliquée, durée, nature et concentration de l'électrolyte, post-traitement chimique ou recuit). La variation de la porosification permet de contrôler le taux de relaxation et donc le taux d'incorporation d'In dans les couches ré-épitaxiées. De plus, la diminution de l'état de contrainte réduit l'effet de ségrégation de surface de l'In dans les couches d'InGaN. La porosification, et en particulier, la taille des pores, pourra varier ultérieurement, lors de la reprise d'épitaxie en fonction de la température appliquée.

Lors de l'étape d), on ré-épitaxie un ou plusieurs empilements 100 ou 110, 200, 300 sur les couches de reprise d'épitaxie 14 des mésas, moyennant quoi on forme des structures de LEDs, et, avantageusement, des structures de LEDs rouge, vert, bleu.

Le ou les empilements de couches déposés à l'étape d) peuvent être obtenus selon une ou plusieurs recettes d'épitaxie de façon à obtenir une première, deuxième et troisième structures de LEDs émettant à différentes longueurs d'onde (avantageusement, dans le bleu, le rouge et le vert respectivement).

Nous allons maintenant décrire plus en détail deux variantes de réalisation du procédé :
- une première variante mettant en oeuvre une étape de porosification (une seule série de mésas est porosifiée) et deux étapes d'épitaxie successives (figures 1A-1J),
- une seconde variante mettant en oeuvre la porosification de deux séries de mésas et une seule étape d'épitaxie (figures 5A-5F).

Nous allons maintenant décrire plus en détail la première variante de réalisation.

L'étape b3) de cette variante consiste à structurer une troisième série de mésas S3, les mésas de la troisième série S3 comprennent une partie de la couche de GaN nid 12, la couche d'ln(x)GaN dopée 13 et la couche de reprise d'épitaxie en In(x)GaN non intentionnellement dopée 14, moyennant quoi les mésas de la troisième série S3 sont chacune isolées électriquement (figure 1B).

L'étape b3) conduit à une isolation électrique de la troisième série de mésas. Ces mésas ne seront pas porosifiées lors de l'étape de porosification électrochimique (étape c)).

Avantageusement, l'étape b1) et l'étape b3) sont réalisées simultanément.

L'étape c) est réalisée comme précédemment décrit.

A l'issue de l'étape c), on obtient, selon cette première variante de réalisation, un pseudo-substrat comprenant (figure 1D):
- des mésas porosifiées (deuxième série de mésas S2) comprenant une couche porosifiée 13 et une couche de reprise d'épitaxie 14 dense relaxée prête pour l'épitaxie rouge,
- des mésas non porosifiées (première série de mésas S1 et troisième série de mésas S3) comprenant une couche dopée 13 non porosifiée et une couche de reprise d'épitaxie 14 dense non relaxée prête pour l'épitaxie bleu et pour l'épitaxie verte.

Avantageusement, le paramètre de maille a final de la mésa porosifiée est de l'ordre de (à température ambiante - typiquement 20°C) : 3,205-3,210 Angs. Un tel paramètre de maille permet d'obtenir dans les puits quantiques InGaN de la LED rouge x_{In} =40%. Les paramètres d'épitaxie correspondant à une telle structure de LED rouge donnent sur une mesa non relaxé tels que celles de la troisième série S3 une incorporation d'In de l'ordre de x_{In} = 25% correspondant à une émission verte. Il est ainsi possible de réaliser une seule étape d'épitaxie pour former les LED vertes et rouges.

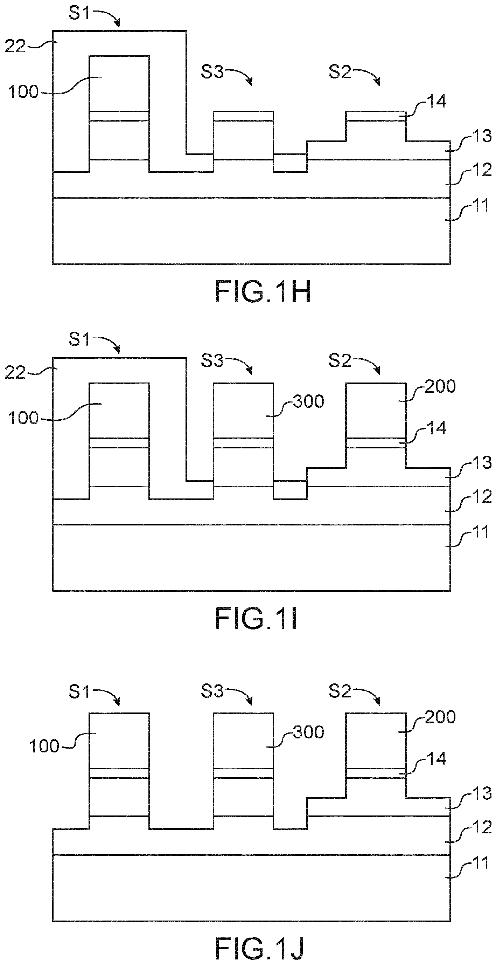

Avantageusement, selon cette première variante de réalisation, les reprises d'épitaxie sont réalisées en deux temps, i.e. il y a deux reprises d'épitaxie :
- une reprise d'épitaxie pour la première série de mésas S1 (figure 1F),
- une seule reprise d'épitaxie pour la deuxième série de mésas S2 et la troisième série de mésas S3 (figure 1I).

A titre illustratif, l'étape d), selon cette première variante de réalisation, comporte les sous-étapes suivantes :
- déposer un premier masque 21, par exemple en SiO₂ ou SiN d'épaisseur par exemple entre 100nm et 1µm, sur la deuxième série de mésas S2 porosifiée et sur la troisième série de mésas S3 (figure 1E),
- réaliser une épitaxie d'un premier empilement 100 sur la première série de mésas S1, moyennant quoi on obtient une première série de LED bleue (figure 1F),
- retirer le premier masque 21, de préférence avec une chimie par voie humide, par exemple avec une solution d'acide fluorhydrique (HF) pour un masque en SiO₂ (figure 1G),
- déposer un deuxième masque 22, par exemple en SiO₂ ou SiN, sur la première série de mésas S1 (figure 1H),
- réaliser une épitaxie en une seule étape d'un même empilement (200, 300) sur la deuxième série de mésas S2 porosifiée et sur la troisième série S3 de mésas, moyennant quoi on forme respectivement une deuxième série de LED rouge et une troisième série de LED verte (figure 1I),
- retirer le deuxième masque 22, de préférence avec une chimie par voie humide, par exemple avec une solution d'acide fluorhydrique (HF) pour un masque en SiO₂ (figure 1J).

Les masques peuvent être réalisés selon les sous-étapes suivantes : dépôt du masque pleine plaque, lithographie et gravure plasma, par exemple, à base de gaz fluorés comme le CHF₃ ou le SF₆.

Pour obtenir des LEDs bleues sur la première série de mésas S1, on pourra utiliser différents empilements 100 ou 110.

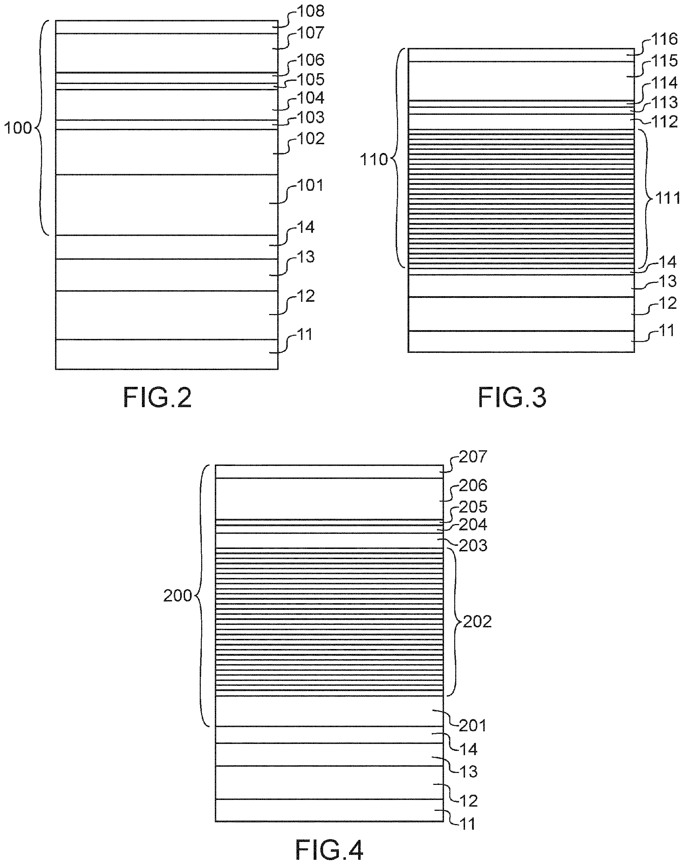

Pour une structure de base 10 de type GaN (x = 0%), on pourra choisir par exemple un empilement réépitaxié 100 comprenant successivement depuis la couche de reprise d'épitaxie (figure 2):
- une couche (' buffer') GaN :Si 101, ayant par exemple une épaisseur inférieure à 1µm,
- une couche d'InGaN/GaN 102 formée de 20 x In_{0,15}GaN/GaN_{0,85} (épaisseurs 2,8nm / 10nm),
- une couche d'espaceur en GaN non intentionnellement dopé 103 de 10nm d'épaisseur par exemple
- une zone active 104 formée de puits quantiques multiples (MQWs), formés de 5 x In_{0,15}Ga_{0,85}N / GaN (épaisseurs 2,5nm / 10 nm),
- une couche d'espaceur en GaN non intentionnellement dopé 105 par exemple de 30nm d'épaisseur,
- une couche de AIGaN :Mg 106 de 15nm d'épaisseur,
- une couche GaN dopée p 107 (200nm),
- une couche de GaN dopée p+++ 108 (20nm).

Pour une structure de base 10 de type InGaN (0% < x ≤ 8%), on pourra choisir par exemple un empilement réépitaxié 110 comprenant successivement depuis la couche de reprise d'épitaxie (figure 3) :
- une couche d'InGaN dopée n 111 formée de 15 x InGaN / GaN (épaisseurs 22nm / 1,8 nm) ou formée d'une seule couche tampon d'InGaN dopée n,
- une zone active 112 formée de puits quantiques multiples (MQWs), formés de 5 x In_{0,15}Ga_{0,85}N / InGaN (épaisseurs 2,5nm / 6 nm),
- une couche de (Ga, In)N nid 113,
- une couche AIGaN dopée p 114,
- une couche GaN dopée p 115 (125nm),
- une couche de GaN dopée p+++ 116 (25nm).

Pour la reprise d'épitaxie unique permettant de former simultanément la deuxième série de LED rouge et la troisième série de LED verte, on choisira par exemple un empilement LED 200 tout InGaN adaptée à la fois à l'épitaxie sur InGaN relaxé et à l'émission rouge, de façon à obtenir une émission rouge sur S2 et verte sur S3 pour les mêmes paramètres de croissance. En jouant sur le degré de porosification des mésas, et donc sur le degré de relaxation, il est possible d'obtenir des longueurs d'onde différentes pour un même procédé d'épitaxie LED. Le taux d'In des différentes couches de la structure LED va en effet varier automatiquement en fonction de l'état de contrainte de la mésa, ce qui conduira à une émission rouge pour la deuxième série S2 et verte pour la troisième série S3.

Le paramètre de maille des mésas S2 doit être de l'ordre de 3.205-3.210 Å, et celui des mésas S3 de l'ordre de celui du GaN (contraint ou non, soit 3.184-3.189 Å).

L'empilement 200 réépitaxié est adapté à l'émission rouge pour les LEDs de la deuxième série de mésas et qui conduira à une émission de vert pour les LEDs de la troisième série de mésas. L'empilement 200 que l'on dépose comprend par exemple depuis la couche de reprise d'épitaxie (figure 4) :
- une couche d'ln(x)GaN 201 avec x compris entre 3 et 6%,
- une couche d'InGaN dopée n 202 formée de 15 x InGaN / GaN (épaisseurs 22nm / 1,8 nm) ou formée d'une seule couche tampon d'InGaN dopée n,
- une zone active 203 formée de puits quantiques multiples (MQWs), formés de 5 x In_{0,40}Ga_{0,60}N / InGaN (épaisseurs 2,5nm / 6 nm),
- une couche de (Ga, In)N nid 204,
- une couche (AI,Ga)N dopée p 205,
- une couche InGaN dopée p 206 (125nm),
- une couche de InGaN dopée p+++ 207 (25nm).

Cet empilement 200 conduit à x_{In} = 25% pour le vert et 40% pour le rouge dans les puits InGaN.

Si les LED vertes et les LEDs rouges ne sont pas faites simultanément, alors les LED vertes sont, avantageusement, réalisées avant les LEDs rouges pour des raisons de budget thermique.

Nous allons maintenant décrire plus en détail la seconde variante de réalisation.

L'étape b3) de cette variante consiste à structurer une troisième série de mésas S3 comprenant une partie de la couche d'ln(x)GaN dopée 13 et la couche de reprise d'épitaxie en In(x)GaN non intentionnellement dopée 14, moyennant quoi les mésas de la troisième série S3 sont interconnectées électriquement entre elles (figure 5B).

L'étape b3) conduit à la formation d'une série de mésas S3 interconnectés électriquement grâce à une gravure jusque dans la couche d'ln(x)GaN dopée 13. Toutes les mésas formées par cette étape de gravure sont connectées électriquement par la couche dopée 13.

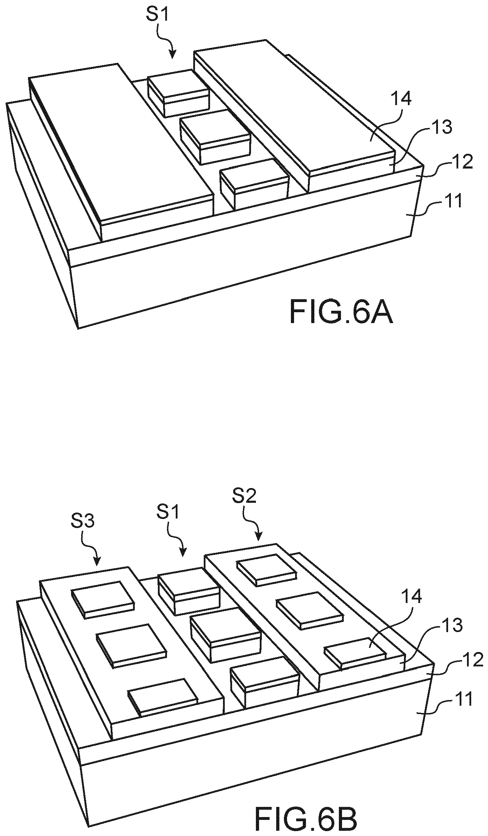

Avantageusement, on réalise l'étape b1) (figure 6A) puis on réalise les étapes b2) et b3) simultanément (figure 6B et 5B). Alternativement, il est possible d'inverser l'ordre des étapes : b2) et b3), puis b1).

Lors de l'étape c), on porosifie la deuxième série de mésas S2 destinées à l'émission de rouge. On choisira par exemple un potentiel E1 que l'on appliquera pendant un temps t1, pour obtenir un taux de porosité p1 et une relaxation r1 (figure 5C).

Le procédé selon cette variante de réalisation, comprend une étape c') additionnelle. Lors de l'étape c'), on porosifie la troisième série de mésas S3 destinées à l'émission de vert. On choisira par exemple un potentiel E2 que l'on appliquera pendant un temps t2, pour taux de porosité p2 et relaxation r2 (figure 5D).

Les taux de porosification p1 et p2 sont très différents avec p1 >>p2. On choisira, avantageusement, deux taux de porosification qui diffèrent de 25% à 50%

Lors des étapes c) et c'), la première série de mésas S1 destinées à l'émission de bleu n'est pas porosifiée.

Les étapes c) et c') peuvent être réalisées simultanément ou consécutivement.

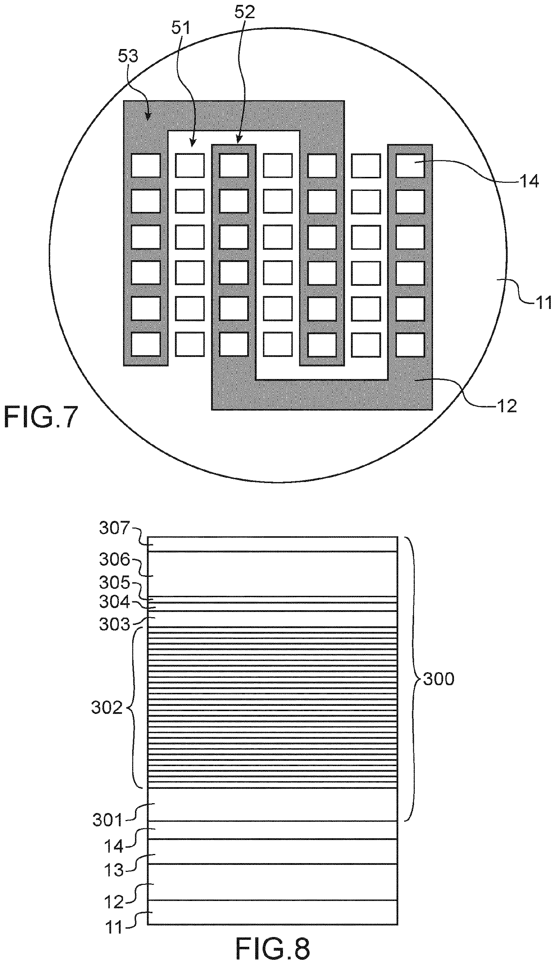

La deuxième série de mésas S2 et la troisième série de mésas S3 sont isolées électriquement l'une de l'autre, chaque série possédant un réseau d'interconnexion qui lui est propre constitué par la couche d'ln(x)GaN dopée (figure 7).

Avantageusement, les paramètres de maille finaux de chacune des mésas après la première reprise d'épitaxie sont : 3,184 Angs pour le bleu (cas de la mésa non porosifiée), 3,202 Angs. pour le vert et 3,238 Angs. pour le rouge.

Avantageusement, on réalisera un masquage de l'espace inter mésa par un diélectrique sélectif avant la croissance des LED (figure 5E).

Le masque de croissance peut être obtenu, par exemple, selon les sous-étapes suivantes : dépôt d'une couche diélectrique ('liner') par exemple en SiN d'environ 80nm par PECVD (dépôt conforme), ouverture du haut des mésas par un procédé auto aligné (sans avoir recourt à une étape de lithographie) : étalement d'un polymère qui peut être une résine de lithographie, amincissement pleine plaque en plasma O₂ pour faire apparaître le haut des mésas tout en laissant de la résine dans les tranchées entre les mésas, puis gravure du SiN en plasma fluoré afin de rendre apparent le haut des mésas, et enfin retrait de la résine.

Finalement, on épitaxie un même empilement de couches sur les trois séries de mésas S1, S2, S3 (figure 5F). De manière très avantageuse, selon cette seconde variante de réalisation du procédé, cette reprise d'épitaxie est réalisée en une seule étape, i.e. une seule et même recette d'épitaxie est réalisée pour déposer l'empilement de couches simultanément sur les trois séries mésas. Les différents taux de porosité et de relaxation des mésas permettant d'obtenir les trois couleurs de LED. L'incorporation d'In dans la totalité de la structure, et notamment dans les puits quantiques est variable en fonction du taux de relaxation de la couche dense des mésas. Plus la couche est relaxée et plus la longueur d'onde d'émission augmente.

Par exemple, on choisira une recette d'épitaxie tout InGaN pour former un empilement 300 conduisant à une structure LED adaptée pour le rouge sur la deuxième série de mésas S2.Cette même recette conduira à une émission bleue sur la première série de mésas S1 et une émission verte sur la troisième série de mésas S3.

L'empilement 300 que l'on dépose comprend successivement depuis la couche de reprise d'épitaxie en InGaN non intentionnellement dopée 13 de la structure de base 10 (figure 8) :
- une couche d'ln(x)GaN 301, avec x allant de 10 à 20%, par exemple 15%,
- une couche d'InGaN dopée n 302 de 350nm, formée de 15 x In_{0,15}Ga_{0,75}N / GaN (épaisseurs 22nm / 1,8nm),
- une zone active 303 formée de puits quantiques multiples (MQWs), formés de 5 x In_{0,40}Ga_{0,60}N / In_{0,15}Ga_{0,85}N (épaisseurs 2,3nm / 5, 7, 11 nm),
- une couche de In_{0,03}Ga_{0,97}N nid 304 (10nm),
- une couche (AI,Ga)N :Mg 305 (20nm),
- une couche de In_{y}Ga_{1-y}N dopée Mg 306 avec y = 10-15% (125nm),
- une couche de In_{y}Ga_{1-y}N dopée p+++ 307 (25nm).

A l'issue du procédé, on obtient une matrice à émission native émettant à au moins deux longueurs d'onde différentes.

On décrit par la suite plus en détail une matrice à émission native émettant à au moins trois longueurs d'onde différentes (de préférence une matrice RGB). La matrice RGB comprend par exemple :
- une structure de base 10 comprenant successivement un substrat 11, une couche de GaN nid 12, une couche d'ln(x)GaN dopée 13 avec x de 0 à 8% et une couche de reprise d'épitaxie en In(x)GaN non intentionnellement dopée 14,
- une première série de mésas S1 formée dans la structure de base comprenant une partie de la couche de GaN nid 12, la couche d'ln(x)GaN dopée 13 et la couche de reprise d'épitaxie en In(x)GaN non intentionnellement dopée 14, la première série de mésas S1 étant recouverte par une première série de LED bleue,
- une deuxième série de mésas S2 formée dans la structure de base 10 comprenant une partie de la couche d'ln(x)GaN dopée 13 et la couche de reprise d'épitaxie en In(x)GaN non intentionnellement dopée 14, la partie de la couche d'ln(x)GaN dopée 13 étant porosifiée, la première série de mésas S2 étant recouverte par une deuxième série de LED rouge,
- une troisième série de mésas S3 formée dans la structure de base 10 et recouverte par une troisième série de LED verte.

Selon une première variante de réalisation, représentée sur la figure 1J, les mésas de la troisième série S3 comprennent une partie de la couche de GaN nid 12, la couche d'ln(x)GaN dopée 13 et la couche de reprise d'épitaxie en In(x)GaN non intentionnellement dopée 14. La troisième LED 300 et la deuxième LED 200 sont avantageusement formées simultanément par épitaxie.

Selon une deuxième variante de réalisation, représentée sur la figure 5F, les mésas de la troisième série S3 comprennent une partie de la couche d'ln(x)GaN dopée 13 et la couche de reprise d'épitaxie en In(x)GaN non intentionnellement dopée 14. La couche d'ln(x)GaN dopée 13 de la troisième série de mésas S3 est porosifiée. La première série de LED la deuxième série de LED 200 et la troisième série de LED 300 sont avantageusement formées simultanément par épitaxie.

### REFERENCES

[1] Even et al., "Enhanced In incorporation in full InGaN heterostructure grown on relaxed InGaN pseudo-substrate », Appl. Phys. Lett. 110, 262103 (2017).
[2] Jang et al., "Electrical and structural properties of GaN films and GaN/InGaN light-emitting diodes grown on porous GaN templates fabricated by combined electrochemical and photoelectrochemical etching", Journal of Alloys and Compounds 589 (2014) 507-512,
[3] EP 3 840 065 A1.
[4] EP 3 840 016 A1.

## Revendications

1. Procédé pour fabriquer une matrice à émission native comprenant les étapes suivantes :
a) fournir une structure de base (10) comprenant successivement un substrat (11), une couche de GaN nid (12), une couche d'ln(x)GaN dopée (13) avec x de 0 à 8% et une couche de reprise d'épitaxie en In(x)GaN non intentionnellement dopée (14),
b1) structurer une première mésa (S1) dans la structure de base (10) comprenant une partie de la couche de GaN nid (12), la couche d'ln(x)GaN dopée (13) et la couche de reprise d'épitaxie en In(x)GaN non intentionnellement dopée (14),
b2) structurer une deuxième mésa (S2) dans la structure de base (10), la deuxième mésa comprenant une partie de la couche d'ln(x)GaN dopée (13) et la couche de reprise d'épitaxie en In(x)GaN non intentionnellement dopée (14), la première mésa (S1) étant isolée électriquement de la deuxième mésa (S2),
c) porosifier par voie électrochimique la couche d'ln(x)GaN dopée (13) de la deuxième mésa (S2),
d1) déposer un premier empilement (100) sur la couche de reprise d'épitaxie en In(x)GaN non intentionnellement dopée (14) de la première mésa (S1), moyennant quoi on obtient une première structure de LED émettant à une première longueur d'onde,
d2) déposer un deuxième empilement (200) sur la couche de reprise d'épitaxie en In(x)GaN non intentionnellement dopée (14) de la deuxième mésa (S2), moyennant quoi on obtient une deuxième structure de LED émettant à une deuxième longueur d'onde.

2. Procédé selon la revendication 1, comportant une étape b3) au cours de laquelle on structure une troisième mésa (S3) dans la structure de base (10) et une étape d3) au cours de laquelle on dépose un troisième empilement (300) sur la couche de reprise d'épitaxie en In(x)GaN non intentionnellement dopée (14) de la troisième mésa (S3), moyennant quoi on obtient une troisième structure de LED émettant à une troisième longueur d'onde.

3. Procédé selon la revendication 2, dans lequel la première structure de LED émet dans le bleu, la deuxième structure de LED émet dans le rouge et la troisième structure de LED émet dans le vert, moyennant quoi on forme une matrice RGB.

4. Procédé selon l'une des revendications 2 et 3, dans lequel la troisième mésa (S3) comprend une partie de la couche de GaN nid (12), la couche d'ln(x)GaN dopée (13) et la couche de reprise d'épitaxie en In(x)GaN non intentionnellement dopée (14), la troisième mésa (S3) étant isolée électriquement de la première mésa (S1) et de la deuxième mésa (S2),
l'étape b3) étant, avantageusement, réalisée simultanément à l'étape b1),
l'étape d3) étant, avantageusement, réalisée simultanément à l'étape d2).

5. Procédé selon la revendication précédente, dans lequel :
- entre l'étape c) et l'étape d1), on dépose un premier masque (21) en SiO₂ ou SiN sur la deuxième mésa (S2) et la troisième mésa (S3), le premier masque (21) étant retiré après l'étape d1), et
- entre l'étape d1) et les étapes d2) et d3), on dépose un deuxième masque (22) en SiO₂ ou SiN sur la première mésa (S1), le deuxième masque (22) étant retiré après les étapes d2) et d3).

6. Procédé selon l'une des revendications 2 et 3, dans lequel la troisième mésa (S3) comprend une partie de la couche d'ln(x)GaN dopée (13) et la couche de reprise d'épitaxie en In(x)GaN non intentionnellement dopée (14), moyennant quoi la troisième mésa (S3) est isolée électriquement de la deuxième mésa (S2),
et en ce que le procédé comprend une étape additionnelle c') au cours de laquelle on porosifie par voie électrochimique la couche d'ln(x)GaN dopée (13) de la troisième mésa (S3),
les étapes d1, d2) et d3) étant, avantageusement, réalisées simultanément.

7. Procédé selon la revendication 6, dans lequel les étapes c) et c') sont réalisées simultanément ou successivement.

8. Procédé selon l'une quelconque des revendications précédentes, dans lequel la couche de GaN nid (12) a une épaisseur comprise entre 100nm et 4µm et/ou la couche d'ln(x)GaN dopée (13) a une épaisseur comprise entre 100nm et 800nm et/ou la couche de reprise d'épitaxie en In(x)GaN non intentionnellement dopée (14) a une épaisseur comprise entre 10nm et 200nm.

9. Matrice à émission native comprenant :
- une structure de base (10) comprenant successivement un substrat (11), une couche de GaN nid (12), une couche d'ln(x)GaN dopée (13) avec x de 0 à 8% et une couche de reprise d'épitaxie en In(x)GaN non intentionnellement dopée (14),
- une première mésa (S1) formée dans la structure de base comprenant une partie de la couche de GaN nid (12), la couche d'ln(x)GaN dopée (13) et la couche de reprise d'épitaxie en In(x)GaN non intentionnellement dopée (14), la première mésa (S1) étant recouverte par une première structure de LED émettant à une première longueur d'onde,
- une deuxième mésa (S2) formée dans la structure de base (10) comprenant une partie de la couche d'ln(x)GaN dopée (13) et la couche de reprise d'épitaxie en In(x)GaN non intentionnellement dopée (14), la partie de la couche d'ln(x)GaN dopée (13) étant porosifiée, la deuxième mésa (S2) étant recouverte par une deuxième structure de LED émettant à une deuxième longueur d'onde.

10. Matrice selon la revendication 9, comprenant une troisième mésa (S3) formée dans la structure de base (10) et recouverte par une troisième structure de LED émettant à une troisième longueur d'onde.

11. Matrice selon la revendication 10, dans laquelle la première structure de LED émet dans le bleu, la deuxième structure de LED émet dans le rouge et la troisième structure de LED émet dans le vert, moyennant quoi on forme une matrice RGB.

12. Matrice selon l'une des revendications 10 et 11, dans laquelle la troisième mésa (S3) comprend une partie de la couche de GaN nid (12), la couche d'ln(x)GaN dopée (13) et la couche de reprise d'épitaxie en In(x)GaN non intentionnellement dopée (14).

13. Matrice selon l'une des revendications 10 et 11, dans laquelle la troisième mésa (S3) comprend une partie de la couche d'ln(x)GaN dopée (13) et la couche de reprise d'épitaxie en In(x)GaN non intentionnellement dopée (14),
et en ce que la couche d'ln(x)GaN dopée (13) de la troisième mésa (S3) est porosifiée.

## Patentansprüche

1. Verfahren zur Herstellung einer nativen Emissionsmatrix, die folgenden Schritte umfassend:
a) Bereitstellen einer Grundstruktur (10), die aufeinanderfolgend ein Substrat (11), eine Schicht aus GaN nid (12), eine Schicht aus In(x)GaN (13), die mit x von 0 bis 8 % dotiert ist, und eine unbeabsichtigt dotierte Schicht der Epitaxie-Wiederaufnahme aus In(x)GaN (14), umfasst,
b1) Strukturieren einer ersten Mesa (S1) in der Grundstruktur (10), einen Teil der Schicht aus GaN nid (12), die dotierte Schicht aus In(x)GaN (13) und die unbeabsichtigt dotierte Schicht der Epitaxie-Wiederaufnahme aus In(x)GaN (14) umfassend,
b2) Strukturieren einer zweite Mesa (S2) in der Grundstruktur (10), wobei die zweite Mesa einen Teil der dotierten Schicht aus In(x)GaN (13) und die unbeabsichtigt dotierte Schicht der Epitaxie-Wiederaufnahme aus In(x)GaN (14) umfasst, wobei die erste Mesa (S1) von der zweiten Mesa (S2) elektrisch isoliert ist,
c) elektrochemisches Porosieren der dotierten Schicht aus In(x)GaN (13) der zweiten Mesa (S2),
d1) Abscheiden eines ersten Stapels (100) auf der unbeabsichtigt dotierten Schicht der Epitaxie-Wiederaufnahme aus In(x)GaN (14) der ersten Mesa (S1), wodurch eine erste LED-Struktur erhalten wird, die mit einer ersten Wellenlänge emittiert,
d2) Abscheiden eines zweiten Stapels (200) auf der unbeabsichtigt dotierten Schicht der Epitaxie-Wiederaufnahme aus In(x)GaN (14) der zweiten Mesa (S2), wodurch eine zweite LED-Struktur erhalten wird, die mit einer zweiten Wellenlänge emittiert.

2. Verfahren nach Anspruch 1, einen Schritt b3) beinhaltend, in dessen Verlauf eine dritte Mesa (S3) in der Grundstruktur (10) strukturiert wird, und einen Schritt d3), in dessen Verlauf ein dritter Stapel (300) auf der unbeabsichtigt dotierten Schicht der Epitaxie-Wiederaufnahme aus In(x)GaN (14) der dritten Mesa (S3) abgeschieden wird, wodurch eine dritte LED-Struktur erhalten wird, die mit einer dritten Wellenlänge emittiert.

3. Verfahren nach Anspruch 2, wobei die erste LED-Struktur in Blau emittiert, die zweite LED-Struktur in Rot emittiert und die dritte LED-Struktur in Grün emittiert, wodurch eine RGB-Matrix gebildet wird.

4. Verfahren nach einem der Ansprüche 2 und 3, wobei die dritte Mesa (S3) einen Teil der Schicht aus GaN nid (12), die dotierte Schicht aus In(x)GaN (13) und die unbeabsichtigt dotierte Schicht der Epitaxie-Wiederaufnahme aus In(x)GaN (14) umfasst, wobei die dritte Mesa (S3) elektrisch von der ersten Mesa (S1) und der zweiten Mesa (S2) isoliert ist,
wobei der Schritt b3) vorteilhafterweise gleichzeitig mit dem Schritt b1) durchgeführt wird,
wobei der Schritt d3) vorteilhafterweise gleichzeitig mit dem Schritt d2) durchgeführt wird.

5. Verfahren nach dem vorhergehenden Anspruch, wobei:
- zwischen dem Schritt c) und dem Schritt d1) eine erste Maske (21) aus SiO₂ oder SiN auf der zweiten Mesa (S2) und der dritten Mesa (S3) abgeschieden wird, wobei die erste Maske (21) nach dem Schritt d1) entfernt wird, und
- zwischen dem Schritt d1) und den Schritten d2) und d3) eine zweite Maske (22) aus SiO₂ oder SiN auf der ersten Mesa (S1) abgeschieden wird, wobei die zweite Maske (22) nach den Schritten d2) und d3) entfernt wird.

6. Verfahren nach einem der Ansprüche 2 und 3, wobei die dritte Mesa (S3) einen Teil der dotierten Schicht aus In(x)GaN (13) und die unbeabsichtigt dotierte Schicht der Epitaxie-Wiederaufnahme aus In(x)GaN (14) umfasst, wodurch die dritte Mesa (S3) von der zweiten Mesa (S2) elektrisch isoliert wird,
und wobei das Verfahren einen zusätzlichen Schritt c') umfasst, in dessen Verlauf die dotierte Schicht aus In(x)GaN (13) der dritten Mesa (S3) elektrochemisch porosiert wird,
wobei die Schritte d1), d2) und d3) vorteilhafterweise gleichzeitig durchgeführt werden.

7. Verfahren nach Anspruch 6, wobei die Schritte c) und c') gleichzeitig oder aufeinanderfolgend durchgeführt werden.

8. Verfahren nach einem der vorhergehenden Ansprüche, wobei die Schicht aus GaN nid (12) eine Dicke zwischen 100 nm und 4 µm aufweist, und/oder die dotierte Schicht aus In(x)GaN (13) eine Dicke zwischen 100 nm und 800 nm aufweist, und/oder die unbeabsichtigt dotierte Schicht der Epitaxie-Wiederaufnahme aus In(x)GaN (14) eine Dicke zwischen 10 nm und 200 nm aufweist.

9. Native Emissionsmatrix, umfassend:
- eine Grundstruktur (10), die aufeinanderfolgend ein Substrat (11), eine Schicht aus GaN nid (12), eine Schicht aus In(x)GaN (13), die mit x von 0 bis 8 % dotiert ist, und eine unbeabsichtigt dotierte Schicht der Epitaxie-Wiederaufnahme aus In(x)GaN (14) umfasst,
- eine erste Mesa (S1), die in der Grundstruktur gebildet ist und einen Teil der Schicht aus GaN nid (12), die dotierte Schicht aus In(x)GaN (13) und die unbeabsichtigt dotierte Schicht der Epitaxie-Wiederaufnahme aus In(x)GaN (14) umfasst, wobei die erste Mesa (S1) von einer ersten LED-Struktur bedeckt ist, die mit einer ersten Wellenlänge emittiert,
- eine zweite Mesa (S2), die in der Grundstruktur (10) gebildet ist, einen Teil der dotierten Schicht aus In(x)GaN (13) und eine unbeabsichtigt dotierte Schicht der Epitaxie-Wiederaufnahme aus In(x)GaN (14) umfassend, wobei der Teil der dotierten Schicht aus In(x)GaN (13) porosiert ist und die zweite Mesa (S2) von einer zweiten LED-Struktur bedeckt ist, die mit einer zweiten Wellenlänge emittiert.

10. Matrix nach Anspruch 9, eine dritte Mesa (S3) umfassend, die in der Grundstruktur (10) gebildet und von einer dritten LED-Struktur bedeckt ist, die mit einer dritten Wellenlänge emittiert.

11. Matrix nach Anspruch 10, wobei die erste LED-Struktur in Blau emittiert, die zweite LED-Struktur in Rot emittiert und die dritte LED-Struktur in Grün emittiert, wodurch eine RGB-Matrix gebildet wird.

12. Matrix nach einem der Ansprüche 10 und 11, wobei die dritte Mesa (S3) einen Teil der Schicht aus GaN nid (12), die dotierte Schicht aus In(x)GaN (13) und die unbeabsichtigt dotierte Schicht der Epitaxie-Wiederaufnahme aus In(x)GaN (14) umfasst.

13. Matrix nach einem der Ansprüche 10 und 11, wobei die dritte Mesa (S3) einen Teil der dotierten Schicht aus In(x)GaN (13) und die unbeabsichtigt dotierte Schicht der Epitaxie-Wiederaufnahme aus In(x)GaN (14) umfasst,
und wobei die dotierte Schicht aus In(x)GaN (13) der dritten Mesa (S3) porosiert ist.

## Claims

1. Method for manufacturing a native emission matrix comprising the following steps:
a) providing a base structure (10) comprising successively a substrate (11), a layer of nid GaN (12), a layer of doped In(x)GaN (13) with x from 0 to 8% and an epitaxy repeat layer of not intentionally doped In(x)GaN (14),
b1) structuring a first mesa (S1) in the base structure (10) comprising a part of the layer of nid GaN (12), the layer of doped In(x)GaN (13) and the epitaxy repeat layer of not intentionally doped In(x)GaN (14),
b2) structuring a second mesa (S2) in the base structure (10), the second mesa comprising a part of the layer of doped In(x)GaN (13) and the epitaxy repeat layer of not intentionally doped In(x)GaN (14), the first mesa (S1) being electrically insulated from the second mesa (S2),
c) electrochemically porosifying the layer of doped In(x)GaN (13) of the second mesa (S2),
d1) depositing a first stack (100) on the epitaxy repeat layer of not intentionally doped In(x)GaN (14) of the first mesa (51), by means of which a first LED structure is obtained emitting at a first wavelength,
d2) depositing a second stack (200) on the epitaxy repeat layer of not intentionally doped In(x)GaN (14), of the second mesa (S2), by means of which a second LED structure is obtained emitting at a second wavelength.

2. Method according to claim 1, including a step b3) during which a third mesa (S3) is structured in the base structure (10) and a step d3) during which a third stack (300) is deposited on the epitaxy repeat layer of not intentionally doped In(x)GaN (14) of the third mesa (S3), by means of which a third LED structure is obtained emitting at a third wavelength.

3. Method according to claim 2, wherein the first LED structure emits in the blue, the second LED structure emits in the red and the third LED structure emits in the green, by means of which an RGB matrix is formed.

4. Method according to one of claims 2 and 3, wherein the third mesa (S3) comprises a part of the layer of nid GaN (12), the layer of doped In(x)GaN (13) and the epitaxy repeat layer of not intentionally doped In(x)GaN (14), the third mesa (S3) being electrically insulated from the first mesa (S1) and from the second mesa (S2),
step b3) advantageously being implemented simultaneously with step b1),
step d3) advantageously being implemented simultaneously with step d2).

5. Method according to the preceding claim, wherein:
- between step c) and step d1), a first mask (21) of SiO₂ or SiN is deposited on the second mesa (S2) and the third mesa (S3), the first mask (21) been removed after step d1), and
- between step d1) and steps d2) and a d3), a second mask (22) of SiO₂ or SiN is deposited on the first mesa (51), the second mask (22) being removed after steps d2) and d3).

6. Method according to one of claims 2 and 3, wherein the third mesa (S3) comprises a part of the layer of doped In(x)GaN (13) and the epitaxy repeat layer of not intentionally doped In(x)GaN (14), by means of which the third mesa (S3) is electrically insulated from the second mesa (S2),
and in that the method comprises an additional step c') during which the layer of doped In(x)GaN (13) of the third mesa (S3) is electrochemically porosified,
steps d1), d2) and d3) advantageously being implemented simultaneously.

7. Method according to claim 6, wherein steps c) and c') are implemented simultaneously or successively.

8. Method according to any one of the preceding claims, wherein the layer of nid GaN (12) has a thickness of between 100 nm and 800 µm and/or the epitaxy repeat layer of not intentionally doped In(x)GaN (14) has a thickness of between 10 nm and 200 nm.

9. Native emission matrix comprising:
- a base structure (10) comprising successively a substrate (11), a layer of nid GaN (12), a layer of doped In(x)GaN (13) with x from 0 to 8% and an epitaxy repeat layer of not intentionally doped In(x)GaN (14),
- a first mesa (S1) formed in the base structure comprising a part of the layer of nid GaN (12), the layer of doped In(x)GaN (13) and the epitaxy repeat layer of not intentionally doped In(x)GaN (14), the first mesa (S1) being covered by a first LED structure emitting at a first wavelength,
- a second mesa (S2) formed in the base structure (10), comprising a part of the layer of doped In(x)GaN (13) and the epitaxy repeat layer of not intentionally doped In(x)GaN (14), the part of the layer of doped In(x)GaN (13) being porosified, the second mesa (S2) being covered by a second LED structure emitting at a second wavelength.

10. Matrix according to claim 9, comprising a third mesa (S3) formed in the base structure (10) and covered by a third LED structure emitting at a third wavelength.

11. Matrix according to claim 10, wherein the first LED structure emits in the blue, the second LED structure emits in the red and the third LED structure emits in the green, by means of which an RGB matrix is formed.

12. Matrix according to one of claims 10 and 11, wherein the third mesa (S3) comprises a part of the layer of nid GaN (12), the layer of doped In(x)GaN (13) and the epitaxy repeat layer of not intentionally doped In(x)GaN (14).

13. Matrix according to one of claims 10 and 11, wherein the third mesa (S3) comprises a part of the layer of doped In(x)GaN (13) and the epitaxy repeat layer of not intentionally doped In(x)GaN (14),
and in that the layer of doped In(x)GaN (13) of the third mesa (S3) is porosified.
